# EUROPÄISCHE PATENTSCHRIFT

(11) **EP 2 306 792 B1**
(45) Veröffentlichungstag und Bekanntmachung des Hinweises auf die Patenterteilung: **19.10.2016**
(21) Anmeldenummer: 10179265.3
(22) Anmeldetag: 24.09.2010
(51) Int. Cl.: H05H 1/24, A01C 1/08

(54) **Verfahren und Vorrichtung zum Behandeln von Objekten mit einem physikalischen Plasma bei Atmosphärendruck**
Method and device for treating objects with a physical plasma at atmospheric pressure
Procédé et dispositif de traitement d'objets à l'aide d'un plasma physique sous pression atmosphérique

(30) Priorität: 24.09.2009 DE 102009044932
(43) Veröffentlichungstag der Anmeldung: 06.04.2011
(73) Patentinhaber: Fachhochschule Hildesheim / Holzminden / Göttingen, 31134 Hildesheim (DE)
(72) Erfinder: Viöl, Wolfgang, 37139, Adelebsen (DE); Avramidis, Georg, 37085, Göttingen (DE); Wascher, Richard, 37083, Göttingen (DE)
(74) Vertreter: REHBERG HÜPPE + PARTNER

(56) Entgegenhaltungen:
- WO-A1-2008/123142
- DE-A1-102006 020 483
- US-A- 2 799 241
- US-A1- 2002 127 327

## Beschreibung

### TECHNISCHES GEBIET DER ERFINDUNG

Die Erfindung bezieht sich auf ein Verfahren und eine Vorrichtung zum Behandeln von Objekten mit einem physikalischen Plasma bei Atmosphärendruck, die die Merkmale des Oberbegriffs des unabhängigen Patentanspruchs 1 bzw. 7 aufweisen.

Bei einem erfindungsgemäßen Verfahren und einer erfindungsgemäßen Vorrichtung ist es nicht entscheidend, bei welchem konkreten Druck die Behandlung der Objekte mit dem physikalischen Plasma erfolgt. Hierbei kann es sich um einen Druck gleich dem oder sehr nahe bei dem Atmosphärendruck handeln, der in der Umgebung der Vorrichtung herrscht. Der Druck kann hiervon jedoch durchaus um 100 hPa oder mehr abweichen. Die Angabe, dass die Vorrichtung zum Behandeln von Objekten mit einem physikalischen Plasma bei Atmosphärendruck vorgesehen ist, zielt nur darauf ab, dass die Behandlung keinen Behandlungsraum erfordert, in dem ein stark vom Atmosphärendruck abweichender Druck einstellbar ist und in den die zu behandelnden Objekte aufwändig ein- bzw. aus dem die behandelnden Objekte aufwändig wieder herausgeschleust werden müssen.

### STAND DER TECHNIK

Ein Verfahren und Vorrichtung mit den Merkmalen des Oberbegriffs des unabhängigen Patentanspruchs 1 bzw. 7 sind aus der DE 102 28 506 A1 bekannt. Hier liegt der Entladungsraum zwischen zwei langgestreckten und parallel zueinander verlaufenden Elektroden, von denen zumindest eine mit einer dielektrischen Abschirmung versehen ist. Durch eine dielektrisch behinderte Entladung zwischen diesen Elektroden wird ein physikalischen Plasma generiert, das durch eine quer zu den Elektroden verlaufende Gasströmung an eine darunter liegende Oberfläche eines zu behandelnden Objekts angeblasen wird. Um das großflächige Objekt vollständig zu behandeln, wird dieses relativ zu den Elektroden durch den neben den Elektroden ausgebildeten Behandlungsraum bewegt. Auch diese vollständige Behandlung erfasst nur die den Elektroden zugekehrte Oberfläche des Objekts.

Eine Weiterentwicklung der aus der DE 102 28 506 A1 bekannten Vorrichtung zur Behandlung von Saatgut, das heißt einem Schüttgut, mit einem physikalischen Plasma bei Atmosphärendruck ist aus der DE 10 2006 020 483 A1 bekannt. Dabei verläuft unterhalb der beiden Elektroden, zwischen denen die Gasströmung hervorgerufen wird, ein geneigtes Förderband, auf dem sich das Saatgut von einem Aufladereservoir zu einem Abladereservoir bewegt. Um dabei eine allseitige Behandlung des Saatguts mit dem physikalischen Plasma zu erreichen, greift an dem Fördeband ein Rüttler an, so dass die einzelnen Körner des Saatguts nicht nur auf dem Förderband ruhig liegend durch den Behandlungsraum hindurchgefördert werden, sondern das Förderband herab rollen und so immer andere Teile ihrer Oberfläche den Elektroden zuwenden.

Weiterhin sind aus der DE 10 2006 020 483 A1 ein Verfahren und eine Vorrichtung zur Behandlung von Saatgut mit einem physikalischen Plasma bei Atmosphärendruck bekannt, die die Merkmale des Oberbegriffs des unabhängigen Patentanspruchs 1 bzw. 8 aufweisen und bei denen mit einem sogenannten Plasmajet ein physikalisches Plasma in einen Behandlungsraum ausgeblasen wird, durch den das Saatgut mit einer Gasströmung von einem Aufladereservoir zu einem Abladereservoir gefördert wird. Turbulenzen der Gasströmung, zu denen auch das aus dem Plasmajet austretende physikalische Plasma beiträgt, sollen dabei eine Umwälzung des Saatguts in den Behandlungsraum und damit eine allseitige Behandlung der Körner des Saatguts durch das physikalische Plasma sicherstellen.

Bei beiden oben beschriebenen, en aus der DE 10 2006 020 483 A1 bekannten Vorrichtungen ist der Behandlungsraum, in dem das physikalischen Plasma auf das Saatgut einwirkt, relativ klein, so dass es schwierig, wenn nicht gar unmöglich ist, eine umfassende und allseitige Behandlung jedes Korns des Saatguts mit dem physikalischen Plasma sicherzustellen. Bei anderen aus der DE 10 2006 020 483 A1 bekannten Vorrichtungen die nicht den Merkmalen des Oberbegriffs des unabhängigen Patentanspruchs 8 entsprechen, wird das physikalische Plasma zwischen einem als Gegenelektrode dienenden Förderband und einer darüber angeordneten Flächenelektrode durch dielektrisch behinderte Entladung generiert und wirkt so in einem größeren Behandlungsraum auf das Saatgut ein. Aber auch hierbei stellt sich das Problem, eine allseitige Behandlung des Saatguts mit dem physikalischen Plasma sicherzustellen. Zudem besteht die Gefahr, dass das Saatgut zwischen den Elektroden heißen Entladungsfilamenten ausgesetzt wird, die das Saatgut schädigen können.

Eine Vorrichtung zur Plasmabehandlung von Schüttgut wäre auch für die Vorbehandlung von Partikeln für die Herstellung von Holzwerkstoff- und anderen Teilchen- oder Faserplatten von Interesse, um die Bindungseigenschaften der Partikel zu verbessern.

Die DE 10 2004 011 118 A1 offenbart eine Extraktionselektrode mit Lochblendenmuster für eine Plasmastrahlquelle, insbesondere eine Hochfrequenz-Plasmastrahlquelle, zum Einsatz in einer Vakuumkammer. Die Extraktionselektrode ist als Trägerplatte mit einem Lochblendenmuster ausgebildet. Sie ist zusätzlich zu Mitteln zum Zünden und Erhalten eines Plasmas in einem Plasmaraum vorgesehen und dient zur Extraktion eines Plasmastrahls aus einem Plasmaraum. Dazu wird an die Extraktionselektrode eine Hochfrequenzspannung angelegt, die wechselweise beschleunigend auf die Ionen und die Elektronen des Plasmas einwirkt. Eingesetzt werden soll die bekannte Extraktionselektrode in Vakuumplasmabeschichtungsverfahren, in denen ein quer zur Strahlrichtung homogener Plasmastrahl auszubilden ist.

Ein Verfahren zum Behandeln von Objekten mit einem physikalischen Plasma, wobei einem Entladungsraum ein Gas zugeführt wird und in dem Entladungsraum durch eine elektrische Ladung aus dem Gas ein physikalisches Plasma generiert wird, ist aus der US 2002/0127327 A1 bekannt.

Eine Plasmastrahlenquelle bei Atmosphärendruck, bei der das Plasma durch Löcher in einer Lochplatte in einen Behandlungsraum eintritt, ist aus der WO 2008/123142 A1 bekannt.

### AUFGABE DER ERFINDUNG

Der vorliegenden Erfindung liegt daher die Aufgabe zugrunde, ein Verfahren und eine Vorrichtung mit den Merkmalen des Oberbegriffs des unabhängigen Patentanspruchs 1 bzw. 7 aufzuzeigen, die insbesondere zur allseitigen Behandlung von Schüttgut, wie beispielsweise Saatgut, mit einem physikalischen Plasma bei Atmosphärendruck geeignet sind.

### LÖSUNG

Erfindungsgemäß wird die Aufgabe durch ein Verfahren mit den Merkmalen des unabhängigen Patentanspruchs 1 und eine Vorrichtung mit den Merkmalen des unabhängigen Patentanspruchs 7 gelöst. Bevorzugte Ausführungsformen des neuen Verfahrens und der neuen Vorrichtung sind in abhängigen Patentansprüchen 2 bis 6 bzw. 8 bis 13 definiert.

### BESCHREIBUNG DER ERFINDUNG

Bei dem neuen Verfahren und der neuen Vorrichtung zur Behandlung von Objekten mit einem physikalischen Plasma bei Atmosphärendruck tritt das physikalische Plasma aus dem Entladungsraum durch einen Lochboden mit einer Vielzahl von Löchern von unten in den Behandlungsraum ein. Durch die Vielzahl der Löcher weist der Bereich, in dem das physikalische Plasma auf die zu behandelnden Objekte einwirkt, eine gewisse Mindestausdehnung auf. Zugleich stellt das durch die Löcher des Lochbodens austretende physikalische Plasma sicher, dass die einzelnen Teilchen eines Schüttguts in dem Behandlungsraum wiederholt umgewälzt und so allseitig mit dem physikalischen Plasma behandelt werden. Dabei kann der Behandlungsraum bei dem neuen Verfahren und der neuen Vorrichtung mit einem relativ hohen Füllungsgrad betrieben werden, ohne dass dadurch die Funktion des neuen Verfahrens oder der neuen Vorrichtung gestört wird. Ganz im Gegenteil kann der hohe Füllungsgrad bei gleichem Durchsatz eine relativ lange Verweildauer der einzelnen zu behandelnden Objekte in dem Behandlungsraum und damit eine umfassende Behandlung mit dem physikalischen Plasma sicherstellen. Die Dichte der zu behandelnden Objekte in dem Behandlungsraum beeinträchtigt nämlich nicht die Erzeugung des physikalischen Plasmas in dem Entladungsraum, in den die zu behandelnden Objekte bei dem neuen Verfahren und der neuen Vorrichtung nicht eintreten. Vielmehr stellt das aus den Löchern des Lochbodens austretende physikalische Plasma auch dann eine Art Sperrluftsystem gegen den Eintritt von zu behandelnden Objekten in den Entladungsraum bereit, wenn die Löcher in dem Lochboden beispielsweise bei einem Saatgut größer sein sollten als die einzelnen zu behandelnden Objekte. So kann über dem Lochboden die Behandlung eines Schüttguts in einer Art Wirbelbett oder sogar in einer Art Fließbett der zu behandelnden Objekte in dem aus dem Lochboden ausströmenden Plasma erfolgen. Zusätzlich kann das aufströmende Plasma als Trennmechanismus dienen, um leichtere Schmutzpartikel aus dem Behandlungsgut zu entfernen, oder um, im Falle von Saatgut als zu behandelnde Objekte, die nicht keimfähigen Körner anhand unterschiedlicher Dichten und/oder Gewichte von den keimfähigen zu trennen. Eine ähnlicher Trennmechanismus kann auch bei anderen Materialien (z.B. Holzspänen) ausgenutzt werden.

Bei der Erfindung bildet das Plasma an der Oberseite des Lochbodens ein die zu behandelnden Objekte abstützendes Plasmakissen entsprechend einem Luftkissen aus. Auf diesem Luftkissen können die zu behandelnden Objekte im Abstand über den Lochboden hinwegschweben, ohne diesen zu berühren. Hieraus ergeben sich auch Vorteile bei der Behandlung von großen plattenförmigen Objekten mit einem physikalischen Plasma bei Atmosphärendruck durch das neue Verfahren und in der neuen Vorrichtung, die auf diesem Luftkissen nahezu reibungslos bewegt werden können, um sie vollflächig zumindest an ihrer dem Lochboden zugekehrten Unterseite zu behandeln.

Die neue Vorrichtung weist eine Druckregeleinrichtung für den Gasdruck in dem Entladungsraum auf, um den Gasdruck in dem Entladungsraum konstant zu halten und/oder um den Gasdruck für die Behandlung der jeweiligen Objekte mit dem physikalischen Plasma einzustellen. Dabei versteht es sich, dass Gasdruck in dem Entladungsraum zumindest über dem Druck in dem Behandlungsraum liegen muss, damit das physikalische Plasma durch den Lochboden in dem Behandlungsraum übertritt. In aller Regel ist dies gleichbedeutend damit, dass der Gasdruck in dem Behandlungsraum zumindest etwas über dem Atmosphärendruck liegt. Der Gasdruck in dem Entladungsraum muss aber nicht auf einen konstanten Wert eingeregelt werden. Vielmehr kann es günstig sein, den Gasdruck in dem Entladungsraum periodisch zu variieren, um das physikalische Plasma pulsweise durch die Löcher in dem Lochboden in den Behandlungsraum austreten zu lassen. Die resultierende Impulse auf die zu behandelnden Objekte können diese in Bewegung setzen, um sie zu transportieren und/oder umzuwälzen.

Das bei der Erfindung in dem Entladungsraum generierte physikalische Plasma ist vorzugsweise ein kaltes Plasma, dessen Gastemperatur in der Nähe der Raumtemperatur liegt und insbesondere keine höheren Temperaturen oberhalb 100 °C, vorzugsweise keine Temperatur oberhalb 50 °C, erreicht.

Konkret kann das physikalische Plasma in dem Entladungsraum durch eine dielektrisch behinderte Entladung zwischen Elektroden generiert werden. Dazu wird vorzugsweise eine hochfrequente Wechselspannung in Form einzelner bipolarer Spannungspulspaare an die Elektroden angelegt, von denen eine mit einer dielektrischen Abschirmung versehen ist.

Dabei kann der Lochboden, durch den das physikalische Plasma in den Behandlungsraum eintritt, eine der Elektroden ausbilden. Vorzugsweise handelt es sich dabei um eine geerdete Elektrode, die keine dielektrische Abschirmung aufweist, um eine elektrische Aufladung des Lochbodens zu vermeiden.

Der Lochboden kann zum Beispiel als mit einzelnen Bohrungen versehene Platte, als Lochblech mit ausgestanzten Löchern, als Lochgitter oder auch als Metallnetz ausgebildet sein. Jede konkrete Ausbildung des Lochbodens ist vorzugsweise an die erforderliche physikalische Stabilität des Behandlungsraums angepasst.

Der Behandlungsraum kann bei dem neuen Verfahren und der neuen Vorrichtung nach oben offen sein; er muss nicht durch einen geschlossenen Behälter begrenzt sein. Vielmehr ist der Behandlungsraum zu entlüften, damit sich kein unerwünschter Gegendruck gegen das einströmende Plasma aufbaut.

Der Lochboden muss nicht eben sein oder horizontal verlaufen. Er kann sogar gezielt geneigt sein, um eine seitliche Förderrichtung für die zu behandelnden Objekte vorzugeben. Dies ist auch dadurch möglich, dass nur die Löcher durch den Lochboden in der Förderrichtung für die zu behandelnden Objekte geneigt sind, so dass das hierdurch austretende physikalische Plasma an der Oberseite des Lochbodens nicht senkrecht nach oben strömt, sondern eine seitliche Bewegungskomponente hat.

Um eine allseitige Behandlung von zu behandelnden Objekten in Form von Schüttgut weiter zu unterstützen, können an der Oberseite des Lochbodens Umwälzelemente für die zu behandelnden Objekte vorgesehen sein, beispielsweise in Form von quer zu der Förderrichtung verlaufender Barrieren oder Stufen.

Auch ist es möglich, dass an dem Lochboden ein Rüttelantrieb angreift. Dabei kann der gesamte Entladungsraum bewegt werden oder nur der Lochboden, selbst wenn der Lochboden eine Elektrode der Entladungsstrecke ausbildet, solange die Rüttelbewegung den Abstand der Elektroden prozentual nicht sehr stark verändert.

Eine ähnliche Auswirkung wie ein auf den Lochboden einwirkender Rüttelantrieb hat eine gepulste Gaszufuhr zu dem Entladungsraum, in deren Folge auch das physikalische Plasma gepulst aus den Löchern in den Lochboden nach oben in dem Behandlungsraum austritt.

Da die Erfindung insbesondere, wenn auch nicht ausschließlich, zur Behandlung von Schüttgut geeignet ist, kann die neue Vorrichtung auf einer Seite des Behandlungsraums eine Schüttgutzuführeinrichtung und in einer Förderrichtung auf den Behandlungsraum auf der anderen Seite des Behandlungsraums eine Schüttgutabführeinrichtung aufweisen.

Vorteilhafte Weiterbildungen der Erfindung ergeben sich aus den Patentansprüchen, der Beschreibung und den Zeichnungen. Die in der Beschreibungseinleitung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Weitere Merkmale sind den Zeichnungen - insbesondere den dargestellten Geometrien und den relativen Abmessungen mehrerer Bauteile zueinander sowie deren relativer Anordnung und Wirkverbindung - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden.

### KURZBESCHREIBUNG DER FIGUREN

Die Erfindung wird im Folgenden anhand von Ausführungsbeispielen unter Bezugnahme auf die beigefügten Zeichnungen näher erläutert und beschrieben.
- **Fig. 1**: skizziert eine erste Ausführungsform der neuen Vorrichtung zur Behandlung von Objekten mit einem physikalischen Plasma bei Atmosphärendruck in einem vertikalen Schnitt.
- **Fig. 2**: skizziert eine Abwandlung der Vorrichtung gemäß Fig. 1 mit geneigten Löchern durch einen einen Behandlungsraum nach unten begrenzenden Lochboden; und
- **Fig. 3**: skizziert eine Ausführungsform der neuen Vorrichtung, bei der der gesamte den Behandlungsraum nach unten begrenzende Lochboden geneigt ist.

### FIGURENBESCHREIBUNG

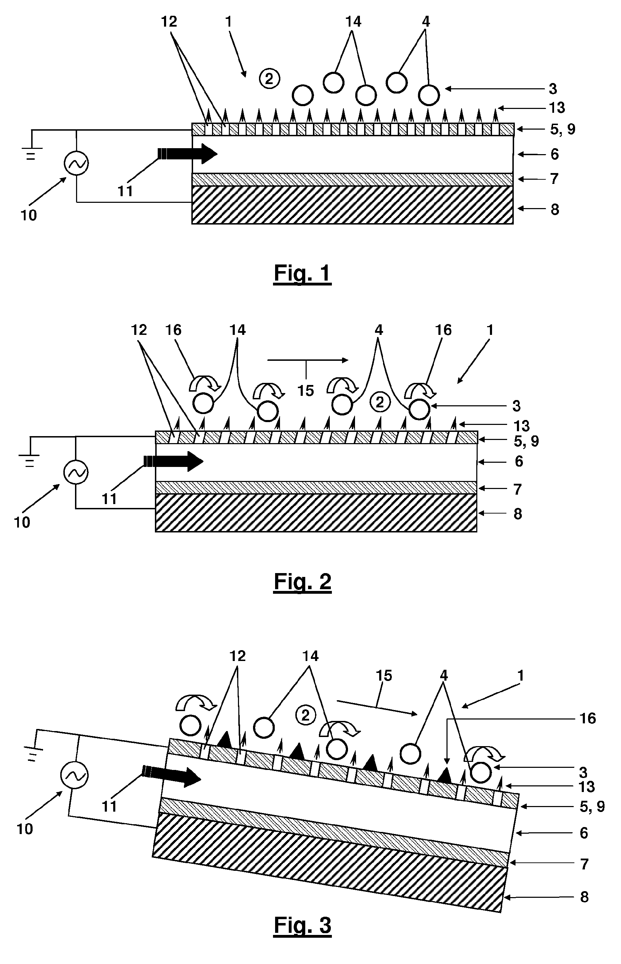

Die in **Fig. 1** skizzierte Vorrichtung 1 weist einen Behandlungsraum 2 zur Behandlung von Schüttgut 3 mit einem physikalischen Plasma auf. Das Schüttgut 3 besteht hier aus einzelnen Körnern 4. Es kann sich dabei um Körner 4 eines Saatguts handeln. Das Schüttgut kann auch aus anderen Partikeln wie beispielsweise Spänen oder Fasern bestehen. Nach unten ist der Behandlungsraum 2 durch einen Lochboden 5 begrenzt. Unter dem Lochboden 5 befindet sich ein Entladungsraum 6, in dem eine dielektrisch behinderte Entladung zwischen einer unteren, mit einem Dielektrikum 7 abgeschirmten Elektrode 8 und einer oberen Elektrode 9 in Form des Lochbodens 5 hervorgerufen wird. Dazu wird eine hochfrequente Wechselhochspannung in Form einzelner bipolarer Spannungspulspaare mit Hilfe eines Wechselhochspannungsgenerators 10 zwischen den Elektroden 8 und 9 angelegt. Dabei ist die den Lochboden 5 bildende Elektrode 9 geerdet. Den Entladungsraum 6 wird kontinuierlich oder pulsweise ein Gas 11 zugeführt, das eine nach oben gerichtete Strömung durch Löcher 12 in dem Lochboden hervorruft. Diese Strömung besteht aus dem in dem Entladungsraum 6 generierten physikalischen Plasma, das so in dem Behandlungsraum 2 auf das Schüttgut 3 einwirkt. Dabei bildet das physikalische Plasma unmittelbar über dem Lochboden 5 ein Plasmakissen 13 aus, auf dem die Körner 4 des Schüttguts 3 "schweben" oder je nach Beladung des Behandlungsraums 2 ein von dem physikalischen Plasma durchströmtes Wirbel- oder Fließbett ausbilden. So wird eine allseitige Behandlung der Körner 4 mit dem physikalischen Plasma, das in dem Entladungsraum 6 generiert wird, sichergestellt. Bei dem Gas 11 kann es sich um Luft oder ein Prozessgas handeln, das eine spezielle Behandlung der Körner 4 des Schüttguts 3 als zu behandelnde Objekte 14 unterstützt oder sogar Voraussetzung hierfür ist. Die Löcher 12 weisen typische Durchmesser im Bereich weniger Zehntelmillimeter bis einiger Millimeter auf.

Die Ausführungsform der Vorrichtung 1, die in Fig. 2 skizziert ist, unterscheidet sich von derjenigen gemäß Fig. 1 dadurch, dass die Löcher 12 in dem Lochboden 5 nach rechts geneigt sind. Hieraus resultiert eine Förderrichtung 15, in der das Schüttgut 13 über den Lochboden 5 bewegt wird. Zudem werden die einzelnen zu behandelnden Objekte 14 in Form der Körner 4 verstärkt umgewälzt, was in Fig. 2 durch Drehpfeile 16 angedeutet ist.

Die Ausführungsform der Vorrichtung 1 gemäß Fig. 3 bildet die Förderrichtung 15 für das Schüttgut 3 dadurch aus, dass der gesamte Lochboden 12 in der Zeichnung von links oben nach rechts unten geneigt ist. Entsprechend geneigt verläuft dabei parallel zu der von dem Lochboden 5 ausgebildeten Elektrode 9 auch die andere Elektrode 8. Die Bewegung und Umwälzung der einzelnen zu behandelnden Objekte 14 wird gemäß Fig. 3 durch quer zu der Förderrichtung 15 verlaufende Barrieren 16 und eine pulsförmige Zuführung des Gases 11 in den Entladungsraum 6 unterstützt, die in einem pulsförmigen Austritt des physikalischen Plasmas aus den Löchern 12 in dem Lochboden 5 resultiert. Alternativ oder zusätzlich wäre es auch möglich, an dem Lochboden 5 bzw. dem gesamten in Fig. 3 gezeigten Aufbau der Vorrichtung 1 bis auf den Generator 10 einen Rüttelantrieb angreifen zu lassen. Auch dieser würde für eine verstärkte Umwälzung der zu behandelnden Objekte 14 auf den Lochboden 5 sorgen. Der Wirkungsgrad eines solchen Rüttelantriebs ist allerdings nur gering, wenn das Plasmakissen 13 über dem Lochboden 12 einen unmittelbaren Kontakt des Lochbodens 12 mit den zu behandelnden Objekten 4 verhindert.

### BEZUGSZEICHENLISTE

- 1: Vorrichtung
- 2: Behandlungsraum
- 3: Schüttgut
- 4: Korn
- 5: Lochboden
- 6: Entladungsraum
- 7: Dielektrikum
- 8: Elektrode
- 9: Elektrode
- 10: Wechselhochspannungsgenerator
- 11: Gas
- 12: Loch
- 13: Plasmakissen
- 14: Objekt
- 15: Förderrichtung
- 16: Drehpfeil

## Patentansprüche

1. Verfahren zum Behandeln von Objekten (14) mit einem physikalischen Plasma bei Atmosphärendruck, wobei einem Entladungsraum (6) ein Gas (11) zugeführt wird und in dem Entladungsraum (6) durch eine elektrische Entladung aus dem Gas (11) ein physikalisches Plasma generiert wird und wobei das physikalische Plasma aus dem Entladungsraum (6) in einen Behandlungsraum (2) übertritt und dort auf die zu behandelnden Objekte (14) einwirkt, wobei das physikalische Plasma aus dem Entladungsraum (6) durch einen Lochboden (5) mit einer Vielzahl von Löchern (12) von unten in den Behandlungsraum (2) eintritt, wobei mit dem physikalischen Plasma an der Oberseite des Lochbodens (5) ein die zu behandelnden Objekte (14) abstützendes Plasmakissen (13) ausgebildet wird

2. Verfahren nach Anspruch 1, **dadurch gekennzeichnet, dass** das physikalische Plasma in dem Entladungsraum (6) als kaltes Plasma generiert wird.

3. Verfahren nach einem der vorhergehenden Ansprüche, **dadurch gekennzeichnet, dass** das physikalische Plasma in dem Entladungsraum (6) durch eine dielektrisch behinderte Entladung zwischen Elektroden (8, 9) generiert wird.

4. Verfahren nach einem der vorhergehenden Ansprüche, **dadurch gekennzeichnet, dass** der Lochboden (5) und/oder Löcher (12) durch den Lochboden (5) in einer Förderrichtung (15) für die zu behandelnden Objekte (14) geneigt ausgerichtet wird/werden.

5. Verfahren nach einem der vorhergehenden Ansprüche, **dadurch gekennzeichnet, dass** das Gas (11) dem Entladungsraum (6) pulsförmig zugeführt wird.

6. Verfahren nach einem der vorhergehenden Ansprüche, **dadurch gekennzeichnet, dass** die zu behandelnden Objekte (14) als Schüttgut auf einer Seite des Behandlungsraums (6) zugeführt und auf dessen anderen Seite abgeführt werden.

7. Vorrichtung (1) zum Behandeln von Objekten (14) mit einem physikalischen Plasma bei Atmosphärendruck, mit einem Entladungsraum (6) und mit einem Behandlungsraum (2), wobei ein Zuführeinrichtung dem Entladungsraum (6) ein Gas (11) zugeführt und ein Hochspannungsgenerator in dem Entladungsraum (6) durch eine elektrische Entladung zwischen Elektroden (8, 9) aus dem Gas (11) ein physikalisches Plasma generiert und wobei das physikalische Plasma aus dem Entladungsraum (6) in den Behandlungsraum (2) übertritt und dort auf die zu behandelnden Objekte (14) einwirkt, wobei zwischen dem Entladungsraum (6) und dem Behandlungsraum (2) ein Lochboden (5) mit einer Vielzahl von Löchern (12) angeordnet ist, der einen unten liegenden Boden des Behandlungsraums ausbildet und durch den das physikalische Plasma aus dem Entladungsraum (6) in den Behandlungsraum (2) eintritt, und wobei eine Druckregeleinrichtung für den Gasdruck in dem Entladungsraum (6) vorgesehen ist.

8. Vorrichtung (1) nach Anspruch 7, **dadurch gekennzeichnet, dass** der Hochspannungsgenerator ein Wechselhochspannungsgenerator (10) ist und das mindestens eine der Elektroden eine dielektrische Abschirmung aufweist, so dass der Hochspannungsgenerator das physikalische Plasma in dem Entladungsraum (6) durch eine dielektrisch behinderte Entladung zwischen den Elektroden (8, 9) generiert.

9. Vorrichtung (1) nach Anspruch 8, **dadurch gekennzeichnet, dass** der Lochboden (5) eine der Elektroden (9) ausbildet.

10. Vorrichtung (1) nach Anspruch 8 oder 9, **dadurch gekennzeichnet, dass** der Lochboden (5) geerdet ist und keine dielektrische Abschirmung aufweist.

11. Vorrichtung (1) nach einem der vorhergehenden Ansprüche 7 bis 10, **dadurch gekennzeichnet, dass** der Lochboden (5) und/oder Löcher (12) durch den Lochboden (5) in einer Förderrichtung (15) für die zu behandelnden Objekte (14) geneigt sind.

12. Vorrichtung (1) nach einem der vorhergehenden Ansprüche 7 bis 11, **dadurch gekennzeichnet, dass** an der Oberseite des Lochbodens (5) Umwälzelemente für die zu behandelnden Objekte (14) vorgesehen sind.

13. Vorrichtung (1) nach einem der vorhergehenden Ansprüche 7 bis 12, **dadurch gekennzeichnet, dass** auf einer Seite des Behandlungsraums (6) eine Schüttgutzuführeinrichtung und auf der anderen Seite eine Schüttgutabführeinrichtung vorgesehen ist.

## Claims

1. Method of treating objects (14) with a physical plasma at atmospheric pressure, wherein a gas (11) is supplied to a discharge chamber (6) and a physical plasma is generated out of the gas (11) by an electric discharge in the discharge chamber (6), and wherein the physical plasma passes over out of the discharge chamber (6) into a treatment chamber (2) and acts upon the objects (14) to be treated here, wherein the physical plasma out of the discharge chamber (6) enters the treatment chamber (2) from below through a sparger plate (5) comprising a multitude of holes (12), wherein a plasma cushion (13) supporting the objects (14) to be treated is formed out of the physical plasma at the upper side of the sparger plate (5).

2. The method of claim 1, **characterised in that** the physical plasma in the discharge chamber (6) is generated as a cold plasma.

3. The method of any of the preceding claims, **characterised in that** the physical plasma in the discharge chamber (6) is generated by means of a dielectric barrier discharge between electrodes (8, 9).

4. The method of any of the preceding claims, **characterised in that** the sparger plate (5) and/or the holes (12) through the sparger plate (5) are tilted in a conveying direction (15) of the objects (14) to be treated.

5. The method of any of the preceding claims, **characterised in that** the gas (11) is supplied to the discharge chamber (6) in pulses.

6. The method of any of the preceding claims, **characterised in that** the objects (14) to be treated are supplied at one side of the treatment chamber (6) and removed at its other side as a loose bulk material.

7. An apparatus (1) for treating objects (14) with a physical plasma at atmospheric pressure, comprising a discharge chamber (6) and comprising a treatment chamber (2), wherein a supply device supplies a gas (11) to the discharge chamber (6) and a high voltage generator generates a physical plasma out of the gas (11) by an electric discharge between electrodes (8, 9), and wherein the physical plasma enters the treatment chamber (2) out of the discharge chamber (6) and acts upon the objects (14) to be treated there, wherein a sparger plate (5) comprising a plurality of holes (12) is arranged between the discharge chamber (6) and the treatment chamber (2), which forms a lower base of the treatment chamber and through which the physical plasma enters into the treatment chamber (2) out of the discharge chamber (6), and wherein a pressure regulation device is provided for the gas pressure in the discharge chamber (6).

8. The apparatus (1) of claim 7, **characterised in that** the high voltage generator is an alternating high voltage generator (10) and that at least one of the electrodes comprises a dielectric barrier so that the high voltage generator generates the physical plasma in the discharge chamber (6) by a dielectric barrier discharge between the electrodes (8, 9).

9. The apparatus (1) of claim 8, **characterised in that** the sparger plate (5) makes up one of the electrodes (9).

10. The apparatus (1) of claim 8 or 9, **characterised in that** the sparger plate (5) is grounded and has no dielectric barrier.

11. The apparatus (1) of any of the preceding claims 7 to 10, **characterised in that** the sparger plate (5) and/or the holes (12) through the sparger plate (5) are tilted in a conveying direction (15) of the objects (14) to be treated.

12. The apparatus (1) of any of the preceding claims 7 to 11, **characterised in that** turnover elements for the objects (14) to be treated are provided at the upper side of the sparger plate (5).

13. The apparatus (1) of any of the preceding claims 7 to 12, **characterised in that** a loose bulk material supply device is provided at one side of the treatment chamber (6) and a loose bulk material removing device is provided at the other side.

## Revendications

1. Procédé de traitement d'objets (14) à l'aide d'un plasma physique sous pression atmosphérique, un gaz (11) étant conduit à un espace de décharge (6), et un plasma physique étant généré à partir du gaz (11) dans l'espace de décharge (6) par une décharge électrique, et le plasma physique pénétrant, à partir de l'espace de décharge (6), dans un espace de traitement (2) et y agissant sur les objets (14) à traiter,
le plasma physique en provenance de l'espace de décharge (6) pénétrant par en bas dans l'espace de traitement (2) à travers un fond perforé (5) muni d'une multiplicité de trous (12), un coussin de plasma (13) supportant les objets (14) à traiter étant constitué avec le plasma physique sur le côté supérieur du fond perforé (5) .

2. Procédé selon la revendication 1, **caractérisé en ce que** le plasma physique est généré dans l'espace de décharge (6) en tant que plasma froid.

3. Procédé selon l'une des revendications précédentes, **caractérisé en ce que** le plasma physique est généré dans l'espace de décharge (6) par une décharge gênée diélectriquement entre des électrodes (8, 9).

4. Procédé selon l'une des revendications précédentes, **caractérisé en ce que** le fond perforé (5) et/ou des trous (12) à travers le fond perforé (5) est/sont orienté (s) de façon inclinée dans une direction de transport (15) des objets (14) à traiter.

5. Procédé selon l'une des revendications précédentes, **caractérisé en ce que** le gaz (11) est conduit à l'espace de décharge (6) sous forme pulsée.

6. Procédé selon l'une des revendications précédentes, **caractérisé en ce que** les objets (14) à traiter sont acheminés en tant que produit en vrac sur un côté de l'espace de décharge (6) et sont évacués sur l'autre côté de celui-ci.

7. Dispositif (1) de traitement d'objets (14) à l'aide d'un plasma physique sous pression atmosphérique, avec un espace de décharge (6) et avec un espace de traitement (2), un gaz (11) étant conduit à l'espace de décharge (6), et un générateur haute tension dans l'espace de décharge (6) générant à partir du gaz (11) un plasma physique par une décharge électrique entre des électrodes (8, 9), et le plasma physique pénétrant, à partir de l'espace de décharge (6), dans l'espace de traitement (2) et y agissant sur les objets (14) à traiter, un fond perforé (5) muni d'une multiplicité de trous (12) étant disposé entre l'espace de décharge (6) et l'espace de traitement (2) et constitue un fond, situé en bas, de l'espace de traitement, et à travers lequel le plasma physique en provenance de l'espace de décharge (6) pénètre dans l'espace de traitement (2), et un dispositif de régulation de pression est prévu dans l'espace de décharge (6) pour la pression du gaz.

8. Dispositif (1) selon la revendication 7, **caractérisé en ce que** le générateur haute tension est un générateur de haute tension alternative (10) et **en ce qu'**au moins une des électrodes présente un blindage diélectrique de telle sorte que le générateur haute tension génère le plasma physique dans l'espace de décharge (6) par une décharge gênée diélectriquement entre les électrodes (8, 9) .

9. Dispositif (1) selon la revendication 8, **caractérisé en ce que** le fond perforé (5) forme une des électrodes (9).

10. Dispositif (1) selon la revendication 8 ou 9, **caractérisé en ce que** le fond perforé (5) est mis à la terre et ne présente pas de blindage diélectrique.

11. Dispositif (1) selon l'une des revendications précédentes 7 à 10, **caractérisé en ce que** le fond perforé (5) et/ou des trous (12) à travers le fond perforé (5) est/sont incliné(s) dans une direction de transport (15) des objets (14) à traiter.

12. Dispositif (1) selon l'une des revendications précédentes 7 à 11, **caractérisé en ce que** des éléments de circulation pour les objets (14) à traiter sont prévus sur le côté supérieur du fond perforé (5) .

13. Dispositif (1) selon l'une des revendications précédentes 7 à 12, **caractérisé en ce qu'**il est prévu un dispositif d'acheminement de produit en vrac sur un côté de l'espace de traitement (6) et un dispositif d'évacuation de produit en vrac sur l'autre côté.
